# EUROPÄISCHE PATENTSCHRIFT

(11) **EP 2 831 608 B1**
(45) Veröffentlichungstag und Bekanntmachung des Hinweises auf die Patenterteilung: **24.10.2018**
(21) Anmeldenummer: 13703813.9
(22) Anmeldetag: 13.02.2013
(51) Int. Cl.: G01R 19/165, H01M 2/20, H01M 10/052, H01M 10/0525, H01M 10/44, H01M 10/48, G01R 31/36

(54) **VERFAHREN ZUM VERSCHALTEN VON BATTERIEZELLEN IN EINER BATTERIE, BATTERIE UND ÜBERWACHUNGSEINRICHTUNG**
METHOD FOR CONNECTING BATTERY CELLS IN A BATTERY, BATTERY AND MONITORING DEVICE
PROCÉDÉ D'INTERCONNEXION DE CELLULES DE BATTERIE DANS UNE BATTERIE, BATTERIE ET DISPOSITIF DE CONTRÔLE

(30) Priorität: 29.03.2012 DE 102012205144
(43) Veröffentlichungstag der Anmeldung: 04.02.2015
(73) Patentinhaber: Robert Bosch GmbH, 70442 Stuttgart (DE)
(72) Erfinder: TENZER, Martin, 71701 Schwieberdingen (DE); POEHLER, Joerg, 70825 Korntal-Muenchingen (DE)
(86) Internationale Anmeldenummer: PCT/EP2013/052802
(87) Internationale Veröffentlichungsnummer: WO 2013/143754

(56) Entgegenhaltungen:
- EP-A1- 2 355 229
- JP-A- 2002 008 732
- US-A1- 2010 237 829
- US-A1- 2011 313 613

## Beschreibung

### Stand der Technik

Die vorliegende Erfindung bezieht sich auf ein Verfahren zum Verschalten von Batteriezellen in einer Batterie, auf eine Batterie, auf eine entsprechende Überwachungseinrichtung sowie auf ein entsprechendes Computerprogrammprodukt.

Üblicherweise wird der Ladezustand (State of Charge - SOC) einer Batterie durch Messen der Ruhespannung an der gesamten Batterie oder an einzelnen Zellen vorgenommen. Ist eine Messung zu einem bestimmten Zeitpunkt nur unter Last möglich, so lässt sich die Ruhespannung aus der gemessenen Spannung, dem Stromfluss und dem Widerstand errechnen. Diese Rechnung kann später korrigiert werden, sobald wieder ein Abgleich mit der Messung der Ruhespannung (ohne Last) möglich ist.

Daneben kann der Stromfluss in die Batterie bzw. aus ihr heraus integriert werden, um darüber eine Aussage über den Ladezustand zu gewinnen. Da sich durch die Integration jedoch der Fehler der Strommessung stetig aufsummiert, muss diese Methodik stets mit dem aus der Ruhespannung berechneten Ladezustand abgeglichen werden.

Die äußerst wichtige Korrelation zwischen Ruhespannung und Ladezustand ist jedoch nur möglich, wenn die Ruhespannungskennlinie (Open Circuit Voltage - OCV) als Funktion des Ladezustands (SOC) eine hinreichende Steigung aufweist, das heißt d(U_{ocv}) / d(SOC) ≠ 0. Allerdings weisen einige wichtige elektrochemische Systeme eine sehr flache Spannungskennlinie auf, zum Beispiel LiFePO₄ und auch Lithium-Schwefel (2 Li + S -> Li₂S). Bislang ist eine Verwendung dieser wichtigen elektrochemischen Systeme in Batterien, deren Ladezustand möglichst genau geschätzt werden muss, wie beispielsweise bei einem Plug-in-Hybrid- und Elektrofahrzeug, nur erschwert möglich.

Die genannten Probleme der Ladezustandsbestimmung können insbesondere gegen Ende einer Entladung dazu führen, dass im Batteriemanagementsystem noch eine Restkapazität angezeigt wird, die tatsächliche Kapazität der Batterie jedoch bereits erschöpft ist. Somit würde der Fahrer eines Elektrofahrzeugs liegen bleiben, obwohl ihm die Ladezustandsanzeige im Auto noch eine verbleibende Kapazität angezeigt hat.

Dieses Problem kann bei den vorgenannten Zellchemie-Systemen dazu führen, dass diese nicht in Elektrofahrzeugen oder ähnlichen Anwendungen zum Einsatz kommen können.

Die DE 10 2010 002 326 A1 offenbart ein Verfahren zum Ausbalancieren von Ladezuständen einer Batterie mit mehreren Batteriezellen sowie ein entsprechendes Batteriemanagementsystem und eine Batterie.

Die Druckschrift US 2011/313613 A1 offenbart ein Batterie-Management-System für in Reihe geschaltete Batterien in der Automobilanwendung, wobei das System der Ladezustandsbestimmung und dem Ladezustandsausgleich dient.

Die Druckschrift EP 2 355 229 A1 offenbart ein Hochstrombatteriesystem für Batterieantriebe. Das Hochstrombatteriesystem hat eine Batteriesystemüberwachungselektronik und eine Mehrzahl von in Reihe geschalteten Batteriemodulen, wobei ein Batteriemodul mittels eines Bypassschalters elektrisch überbrückt werden kann.

Die Druckschrift US 2010/237829 A1 offenbart ein Überwachungssystem für Batteriesysteme beziehungsweise Batteriezellen mittels eines Überbrückungsschaltkreises.

Die Druckschrift JP 2002 008732 A offenbart eine Überwachungsvorrichtung für eine Batterie, um den Ladungsausgleich zwischen Batteriezellen der Batterie zu verbessern.

### Offenbarung der Erfindung

Vor diesem Hintergrund wird mit der vorliegenden Erfindung Verfahren zum Verschalten von Batteriezellen in einer Batterie, eine Überwachungseinrichtung die dieses Verfahren verwendet, eine Batterie, in welcher die Batteriezellen angeordnet sind sowie schließlich ein entsprechendes Computerprogrammprodukt gemäß den Hauptansprüchen vorgestellt. Vorteilhafte Ausgestaltungen ergeben sich aus den jeweiligen Unteransprüchen und der nachfolgenden Beschreibung.

Die vorliegende Erfindung schafft ein Verfahren zum Verschalten von Batteriezellen in einer Batterie, wobei die Batterie eine Mehrzahl von Mess-Batteriezellen und zumindest eine Standard-Batteriezelle in einer Reihenschaltung aufweist, wobei die Mess-Batteriezellen und die Standard-Batteriezelle eine gleiche Zellchemie aufweisen, wobei eine Standard-Batteriezelle mindestens eine Nominalkapazität aufweist, die größer als eine Nominalkapazitätsschwelle ist, wobei die Mess-Batteriezellen jeweils eine Nominalkapazität aufweisen, die kleiner als die Nominalkapazitätsschwelle ist, wobei die Mess-Batteriezellenurversion jeweils eine schaltbare Überbrückung aufweisen, wobei das Verfahren die folgenden Schritte aufweist:
Überwachen eines Ladezustands der Mess-Batteriezellen;
Überbrücken einer Mess-Batteriezelle unter Verwendung der schaltbaren Überbrückung, wenn der Ladezustand der Mess-Batteriezelle eine vordefinierte Ladezustandsschwelle unterschreitet;
Anordnen der Mehrzahl von Mess-Batteriezellen, bei dem die Mess-Batteriezellen entsprechend ihrer jeweiligen Kapazität in der Reihenschaltung aufsteigend angeordnet werden; und
Bestimmen des Ladezustands der Batterie unter Verwendung des Ladezustands der Mess-Batteriezellen und/oder eines im Schritt des Überbrückens ausgegebenen Überbrückungssignals.

Unter einer Batteriezelle kann ein wiederaufladbarer Speicher für elektrische Energie auf elektrochemischer Basis verstanden werden. Unter einer Batteriezelle kann eine wiederaufladbare Sekundärzelle, ein Sekundärelement beziehungsweise ein Akkumulator verstanden werden. Unter einer Batterie kann eine Zusammenschaltung mehrerer Batteriezellen verstanden werden. Die Batteriezellen in einer Batterie können die gleiche Zellchemie aufweisen. Die Batterie kann in einem Fahrzeug eingesetzt werden. Bei dem Fahrzeug kann es sich um ein Kraftfahrzeug, beispielsweise einen Personenkraftwagen, einen Lastkraftwagen oder ein sonstiges Nutzfahrzeug handeln. Das Fahrzeug kann mit einem Hybrid-Antrieb ausgestattet sein oder es kann sich um ein Elektrofahrzeug handeln. Die Batterie kann in anderen Geräten und/oder Anwendungen zum Einsatz kommen. Die Ladungsmenge oder Kapazität, die eine Batteriezelle speichern kann, kann als Nominalkapazität bezeichnet werden. Die Kapazität oder Ladungsmenge einer Batteriezelle kann die Menge an elektrischer Ladung angeben, die eine Batteriezelle liefern beziehungsweise speichern kann, und kann entweder als Nominalkapazität oder als Reservekapazität bezeichnet werden. Unter einer Nominalkapazitätsschwelle kann ein vordefinierter Grenzwert oder Schwellwert für einen nominalen oder maximalen Ladezustand einer Batteriezelle verstanden werden. Unter einem Ladezustand kann die aktuelle Ladungsmenge oder Kapazität verstanden werden, welche zu einem definierten Zeitpunkt in der Batteriezelle vorhanden ist. Der Ladezustand kann weiterhin als Restkapazität bezeichnet werden. Der Ladezustand kann gleich oder kleiner der Nominalkapazität der Batteriezelle sein. Unter einer vordefinierten Ladezustandsschwelle kann eine Schwelle oder ein Grenzwert für den aktuellen Ladezustand verstanden werden. Die Ladezustandsschwelle kann einen Wert zwischen keiner Kapazität oder Ladung und der Nominalkapazität der Batteriezelle einnehmen. Eine Batteriezelle kann eine schaltbare Überbrückung aufweisen. Eine schaltbare Überbrückung kann Strom eines Stromkreislaufs über die Batteriezelle leiten oder alternativ an der Batteriezelle vorbei, das heißt, die Batteriezelle überbrücken. Dabei kann eine schaltbare Überbrückung von einem Signal geschaltet werden.

Die Erfindung basiert auf der Erkenntnis, dass eine Verbesserung der Bestimmung des Ladezustands einer Batterie durch eine Anordnung von einer Mehrzahl von einer Mess-Batteriezellen, die eine geringere Nominalkapazität als eine Standard-Batteriezelle aufweisen, in einer Batterie möglich ist. Der Ladezustand einer Batterie ist gegen Ende der Entladung schwer zu bestimmen und die ungenaue Bestimmung des Ladezustands kann sich in plötzlich abfallender Batterieleistung zeigen. Der Ladezustand einer Batterie kann durch ein Messen der Ruhespannung der Batterie bestimmt werden, jedoch ist in vielen Anwendungsfällen nur eine Messung unter Last möglich. Eine Korrelation zwischen der Ruhespannung und dem Ladezustand ist jedoch nur möglich, wenn eine Ruhespannungskennlinie als Funktion des Ladezustands eine hinreichende Steigung aufweist. Durch ein entsprechendes erfindungsgemäßes Verfahren kann zu zumindest einem bestimmten Zeitpunkt der Entladung der Batterie der Ladezustand zuverlässig bestimmt werden. Hierzu können in einen Strang von Bakterienzellen gleicher Zellchemie und nominal gleicher Nominalkapazität Batteriezellen mit einer geringeren und bekannten Nominalkapazität geschaltet werden, hier als Mess-Batteriezelle bezeichnet. Kurz vor einer kompletten Entladung einer solchen Mess-Batteriezelle kann eindeutig den Ladezustand beispielsweise anhand einer Spannungsmessung festgestellt werden, und somit den Ladezustand der Batterie bestimmen. Wenn die Mess-Batteriezelle an dem Punkt kurz vor der vollständigen Entladung steht, kann sie mit einer schaltbaren Überbrückung aus der Reihenschaltung herausgenommen werden, um die Batterie weiterhin nutzbar zu halten. Dabei kann beispielsweise eine Mess-Batteriezelle, welche eine Nominalkapazität von 80% einer Standard-Batteriezelle aufweist, in der Batterie eingesetzt werden. Wird bei der Überwachung der Mess-Batteriezelle nun festgestellt, dass diese kurz vor der vollständigen Entladung steht, so kann die Mess-Batteriezelle überbrückt werden, um die Batterie funktionstüchtig zu halten und es ist bekannt, dass die Batterie insgesamt bereits eine Kapazität von 80% ihrer ursprünglichen Nominalkapazität aufgebraucht hat und maximal einen Ladezustand von 20% ihrer Nominalkapazität aufweist. Das Abgreifen der Spannung an der Mess-Batteriezelle ermöglicht es dem Anwender eine sichere Abschätzung der Restkapazität zu diesem diskreten Zeitpunkt.

Die Mess-Batteriezelle und die Standard-Batteriezelle weisen die gleiche Zellchemie auf, wobei die Mess-Batteriezelle eine geringere Nominalkapazität oder maximale Kapazität aufweist, als die Nominalkapazität der Standard-Batteriezelle, beispielsweise weist die Mess-Batteriezelle eine Nominalkapazität von 85% der Nominalkapazität der Standard-Batteriezelle auf. Über eine Messung der Batteriespannung kann ein Rückschluss über die Restkapazität in einer Batterie getroffen werden. Da dies je nach verwendeter Zellchemie sehr ungenau sein kann und sich dadurch für den Ladezustand der Batterie eine falsche, zu hoch angesetzte, Restkapazität ergeben kann, ist der erfindungsgemäße Ansatz neben der Batteriespannung auch die Batteriezellenspannung der als Mess-Batteriezellen bezeichneten Batteriezellen zu messen. Kurz vor der vollständigen Entladung ergibt sich ein charakteristischer Spannungsabfall, sodass eine Aussage über die bis jetzt verbrauchte Energiemenge respektive Kapazität der Batterie treffen lässt. Die fast vollständig entladene Mess-Batteriezelle kann nun überbrückt werden und die Batterie kann noch bis zum Aufbrauchen der Kapazität der Batterie verwendet werden.

Gemäß einer Ausführungsform können die Mess-Batteriezellen als austauschbare Mess-Batteriezellen in der Batterie ausgebildet sein. Durch die geringere Kapazität der Mess-Batteriezellen können Alterungsphänomene sich unterschiedlich auswirken als bei einer Standard-Batteriezelle. Die Gestaltung einer Mess-Batteriezelle als austauschbare Einheit kann es erlauben, diesem Umstand Rechnung zu tragen. Als austauschbare Mess-Batteriezelle kann eine solche leichter ausgetauscht werden. Die Kosten für einen solchen Austausch können gering sein im Vergleich zu dem hohen Nutzen der durch eine Mess-Batteriezelle erreichbaren genaueren und sicheren Restkapazitätsabschätzung vor einem nächsten Ladezyklus.

Günstig ist es auch, wenn im Schritt des Anordnens einer Mehrzahl von Mess-Batteriezellen in der Reihenschaltung angeordnet werden, insbesondere mit unterschiedlichen Nominalkapazitäten. Durch den Einsatz einer Mehrzahl von Mess-Batteriezellen kann die Restkapazität der Batterie an einer Mehrzahl diskreter Zeitpunkte bestimmt werden. Dies kann die Robustheit des Verfahrens verbessern. Dabei kann es von Vorteil sein, wenn eine Mess-Batteriezelle aufgrund ihrer aufgebrauchten Kapazität überbrückt wird, diese durch eine andere Batteriezelle, die bis dahin überbrückt war, in der Reihenschaltung der Batterie zu ersetzen, um die Ausgangsspannung der Batterie konstant zu halten. Ferner kann im Schritt des Anordnens eine Mehrzahl von Mess-Batteriezellen entsprechend ihrer jeweiligen Kapazität in der Reihenschaltung aufsteigend angeordnet werden. Durch die geordnete Reihenfolge der Mess-Batteriezellen kann eine Auswertung des Ladezustands der Batterie leichter erfolgen.

Günstig ist es ferner, wenn gemäß einer Ausführungsform der vorliegenden Erfindung in einem Schritt des Anordnens einer Vielzahl von Standard-Batteriezellen in der Reihenschaltung angeordnet werden. Unter einer Vielzahl von Standard-Batteriezellen kann eine Anzahl von mindestens drei Standard-Batteriezellen verstanden werden. Insbesondere Elektrofahrzeuge oder Plug-in-hybrid-Fahrzeuge verwenden Batterien mit einer hohen Ausgangsspannung von beispielsweise 300 V. Eine einzelne Batteriezelle kann beispielsweise nur eine Spannung im einstelligen Voltbereich liefern. In einem solchen Fall kann durch eine Reihenschaltung einer Vielzahl von Standard-Batteriezellen eine entsprechende Ausgangsspannung der Batterie erreicht werden.

Um neben der Steigerung der nutzbaren elektrischen Spannung mittels einer Reihenschaltung der Batteriezellen auch eine Steigerung der nutzbaren Kapazität einer Batterie und deren Belastbarkeit durch hohe Ströme zu erreichen, können im Schritt des Anordnens eine Mehrzahl von Mess-Batteriezellen und Standard-Batteriezellen in der Reihenschaltung und eine weitere Mehrzahl von Mess-Batteriezellen und Standard-Batteriezellen in einer weiteren Reihenschaltung innerhalb einer Batterie angeordnet werden. Durch die Parallelschaltung von zumindest zwei Reihenschaltungen kann die nutzbare Kapazität der Batterie erhöht werden.

Günstig ist ferner eine Ausführungsform der vorliegenden Erfindung, bei der im Schritt des Überbrückens die zumindest eine Mess-Batteriezelle überbrückt wird, wenn der Ladezustand der zumindest einen Mess-Batteriezelle eine weitere vordefinierte Ladezustandsschwelle überschreitet, wobei die weitere vordefinierte Ladezustandsschwelle der Nominalkapazität der Mess-Batteriezelle entspricht. Durch die geringere Nominalkapazität einer Mess-Batteriezelle gegenüber einer Standard-Batteriezelle wird die Mess-Batteriezelle während eines Ladevorgangs der Batterie schneller einen Ladezustand erreichen, der der Nominalkapazität der Mess-Batteriezelle entspricht und somit vollgeladen sein. Um eine Überladung der Mess-Batteriezelle zu vermeiden, kann es sinnvoll sein, die Mess-Batteriezelle zu überbrücken.

Die vorliegende Erfindung schafft ferner eine Überwachungseinrichtung, die ausgebildet ist, um die Schritte des erfindungsgemäßen Verfahrens in entsprechenden Einrichtungen durchzuführen bzw. umzusetzen. Auch durch diese Ausführungsvariante der Erfindung in Form einer Überwachungseinrichtung kann die der Erfindung zugrunde liegende Aufgabe schnell und effizient gelöst werden.

Unter einer Überwachungseinrichtung kann vorliegend ein elektrisches Gerät verstanden werden, das Sensorsignale verarbeitet und in Abhängigkeit davon Steuer- und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Überwachungseinrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Die vorliegende Erfindung schafft ferner eine Batterie, die eine Mehrzahl von Batteriezellen gleicher Zellchemie in einer Reihenschaltung aufweist, wobei die Batterie die folgenden Merkmale aufweist:
zumindest eine Standard-Batteriezelle, die mindestens eine Nominalkapazität aufweist, die größer als eine Nominalkapazitätsschwelle ist;
eine Mehrzahl von Mess-Batteriezellen, die jeweils eine Nominalkapazität aufweisen; die kleiner als die Nominalkapazitätsschwelle ist, wobei die Mess-Batteriezellen jeweils eine schaltbare Überbrückung aufweisen und entsprechend ihrer jeweiligen Kapazität in der Reihenschaltung aufsteigend angeordnet sind; und
eine Überwachungseinrichtung gemäß Anspruch 6.

Eine derartige Ausführungsform der Erfindung bietet den Vorteil der einfacheren Bestimmung des Ladezustands der Batterie durch die Integration aller Komponenten für eine verbesserte Bestimmung des Ladezustands.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert sein kann und zur Durchführung des Verfahrens nach einer der vorstehend beschriebenen Ausführungsformen verwendet wird, wenn das Programmprodukt auf einem Computer oder einer Vorrichtung ausgeführt wird.

Die Erfindung wird nachstehend anhand der beigefügten Zeichnungen beispielhaft näher erläutert. Es zeigen:
- Fig. 2: eine schematische Darstellung einer weiteren Batterie gemäß einem Ausführungsbeispiel der vorliegenden Erfindung;
- Fig. 3: eine schematische Darstellung einer Reihenschaltung aus Mess-Batteriezellen und Standard-Batteriezellen gemäß einem Ausführungsbeispiel der vorliegenden Erfindung;
- Fig. 4: ein Ablaufdiagramm eines Ausführungsbeispiels der vorliegenden Erfindung;
- Fig. 5: ein Spannungsverlauf für Batteriezellen gleicher Zellchemie mit jeweils unterschiedlicher Nominalkapazität gemäß einem Ausführungsbeispiel der vorliegenden Erfindung; und
- Fig. 6: ein Spannungsverlauf für Batteriezellen gleicher Zellchemie mit jeweils unterschiedlicher Nominalkapazität gemäß einem Ausführungsbeispiel der vorliegenden Erfindung.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

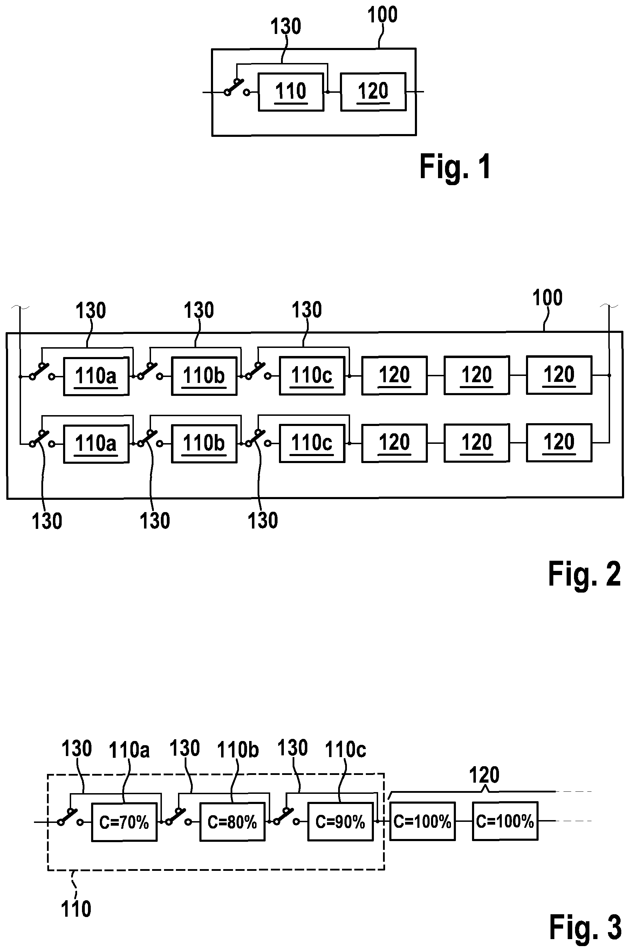

Fig. 2 zeigt eine schematische Darstellung einer weiteren Batterie 100 gemäß einem Ausführungsbeispiel der vorliegenden Erfindung. In zwei parallel angeordneten Reihenschaltungen sind je Reihenschaltung drei Mess-Batteriezellen 110 und drei Standard-Batteriezellen 120 angeordnet. Die Batteriezellen, sowohl die Mess-Batteriezellen 110 als auch die Standard-Batteriezellen 120, weisen die gleiche Zellchemie auf. Jeder Mess-Batteriezelle 110 ist eine schaltbare Überbrückung 130 zugeordnet, welche in der überbückenden Stellung dargestellt ist. Die Standard-Batteriezellen weisen eine Nominalkapazität auf, die als Referenz mit 100% angegeben werden kann. Da die Nominalkapazität produktions- und lagerungsbedingt jeder einzelnen Batteriezelle variieren kann, handelt es sich bei der hier referenzierten

Nominalkapazität um eine Nominalkapazitätsschwelle, die von den Standard-Batteriezellen 120 mindestens erreicht wird. Die Mess-Batteriezellen 110 weisen eine geringere Nominalkapazität als die Standard-Batteriezellen 120 auf. In einem Ausführungsbeispiel weist die Mess-Batteriezelle 110a eine Nominalkapazität von 70% der Nominalkapazität der Standard-Batteriezelle 120 auf, die Mess-Batteriezelle 110b weist eine Nominalkapazität von 80 % der Nominalkapazität der Standard-Batteriezelle 120 auf und die Mess-Batteriezelle 110c weist eine Nominalkapazität von 90 % der Nominalkapazität der Standard-Batteriezelle 120 auf. Die in Fig. 2 gezeigte Anordnung der Mess-Batteriezellen 110 und der Standard-Batteriezellen 120 erlaubt es, an drei diskreten Zeitpunkten den Ladezustand bzw. die Restkapazität der Batterie 100 zuverlässig zu bestimmen. Da in den beiden gezeigten Reihenschaltungen jeweils eine Mess-Batteriezelle 110a mit einer Nominalkapazität von 70 % im Vergleich zur Standard-Batteriezelle 120 angeordnet ist, kann für die Bestimmung einer Restkapazität der Batterie 100 von 30 % ein Mittelwert über die beiden anhand der Mess-Batteriezelle 110a ermittelten diskreten Zeitpunkte ermittelt werden. Die zwei Anschlüsse der beiden parallel angeordneten Reihenschaltungen sind weiterhin von dem Inneren der Batterie 100 nach außen geführt. Die zwei Anschlüsse weisen eine entgegengesetzte Polarität auf.

In einem weiteren, in Fig. 2 nicht gezeigten Ausführungsbeispiel, kann die Anzahl der Standard-Batteriezellen 120 in beiden Reihenschaltungen erhöht werden, um die an der Batterie abgreifbare Spannung zu erhöhen. Von Vorteil ist auch das bei einer großen Anzahl von Standard-Batteriezellen 120 der durch das Überbrücken einer Mess-Batteriezelle 110 verursachte Spannungsabfall prozentual kleiner ausfällt. Alternativ kann der durch das Überbrücken einer Mess-Batteriezelle 110 verursachte Spannungsabfall auch durch das Zuschalten einer weiteren Batteriezelle in der Reihenschaltung ausgeglichen werden.

Gemäß einem Ausführungsbeispiel der Erfindung kann die Ladezustandsbestimmung gegen Ende der Entladung so verbessert werden, dass ein plötzliches, unvorhergesehenes Abfallen der Batterieleistung ausgeschlossen werden kann. Stattdessen soll durch einen zu bestimmten Zeitpunkten der Entladung wirksamen Mechanismus bewirkt werden, dass zum Beispiel bei 70%, 80% und 90% der Entladung eine sichere und zuverlässige Ladezustandsbestimmung möglich ist, die somit gestaffelt auf das nahende Ende der Entladung hinweist.

Das hier vorgestellte Ausführungsbeispiel der Erfindung ist insbesondere bei Batterien 100 mit einer Zellchemie mit sehr flach verlaufender Spannungskennlinie überaus sinnvoll. Um eventuell auftretende Alterungsphänomene, die bei den Zellen 110 mit geringerer Kapazität in anderem Maße auftreten könnten als bei den restlichen Zellen 120, zu kompensieren, lassen sich diese Zellen 110 als austauschbare Einheit ausführen. Dadurch ist es möglich, diese Zellen 110 bei Bedarf leicht auszutauschen, zum Beispiel im Rahmen eines regelmäßigen Kundendienstes am Fahrzeug. Die Kosten für diesen Austausch sind sehr gering im Vergleich zum hohen Nutzen der hierdurch deutlich genaueren und vor allem auch deutlich sichereren Ladezustandsabschätzung bei geringer verbleibender Restkapazität vor dem nächsten Ladevorgang.

Da eine Elektrofahrzeug-Batterie 110 im Allgemeinen aus mehreren parallel verschalteten Reihensträngen, wie in Fig. 3 dargestellt, besteht, können Zellen 110 mit unterschiedlicher Kapazität in jeden der Reihenstränge integriert werden, um dort eine genaue und verlässliche Ladezustands-Abschätzung beziehungsweise Vorhersage des Entladeendes zu ermöglichen.
Der Aufwand hierfür ist sehr gering, wie folgende Abschätzung für eine Elektrofahrzeug-Batterie aus Li-Schwefel-Zellen zeigt.

Dabei werden für die her vollgestellte Betrachtung die folgenden Annahmen vorausgesetzt:

| | |
|---|---|
| Kapazität Einzelzelle | 40 Ah (übliche Größe) |
| Energieinhalt Batterie | 24 kWh |
| Mittlere Zellspannung LiS | 2,1 V |

Aus den genannten, realistischen Annahmen ergibt sich ein Energieinhalt pro Zelle von 84 Wh. Für die Gesamtenergie der Batterie 100 sind somit 286 Zellen notwendig. Um durch Reihenschaltung auf die im Elektrofahrzeug übliche Spannung von ca. 300 V zu kommen, sind rund 142 Zellen in Reihe nötig. Somit besteht die gesamte Batterie aus nur 2 parallel geschalteten Strängen, die wiederum aus 142 Zellen in Reihe aufgebaut sind. In diesem Beispiel sind gerade einmal 2x3 Zellen (mit 70%, 80% höheren und 90% Nominalkapazität) nötig, um die Ladezustandsbestimmung deutlich zu verbessern.

Fig. 3 zeigt eine schematische Darstellung einer Reihenschaltung aus Mess-Batteriezellen und Standard-Batteriezellen gemäß einem Ausführungsbeispiel der vorliegenden Erfindung. In einer Reihenschaltung sind drei Mess-Batteriezellen 100 vor eine Reihe von Standard-Batteriezellen 120 geschaltet. In Fig. 3 sind zwei Standard-Batteriezellen 120 dargestellt. Die Mess-Batteriezellen 110 weisen eine zu den Standard-Batteriezellen 120 geringere Nominalkapazität auf. Die Nominalkapazität der Standard-Batteriezellen 120 wird hier mit 100 % bezeichnet. Die Mess-Batteriezelle 110a weist eine Kapazität von 70 % der Nominalkapazität einer Standard-Batteriezelle 120 auf. Die Mess-Batteriezelle 110b weist eine Kapazität von 80 % der Nominalkapazität einer Standard-Batteriezelle 120 auf. Die Mess-Batteriezelle 110c weist eine Kapazität von 90 % der Nominalkapazität einer Standard-Batteriezelle 120 auf. Die drei Mess-Batteriezellen 110 weisen jeweils eine schaltbare Überbrückung 130 auf. Die schaltbare Überbrückung 130 ist jeweils in der die Mess-Batteriezelle 110 überbrückenden Schalterstellung dargestellt.

Um die Ladezustandsbestimmung gegen Ende einer Entladung zu unterstützen, lassen sich in jeden Reihenstrang, aus denen eine Batterie in der Regel aufgebaut ist, einige Zellen mit jeweils anderer Kapazität einbauen. In Fig. 3 ist diese Anordnung beispielhaft dargestellt. Vor den hier drei Zellen 120, die allesamt die nominale Kapazität aufweisen, werden einige Zellen 110 gleicher Zellchemie in Reihe davor geschaltet, die eine niedrigere und in sich gestaffelte Kapazität aufweisen. In Fig. 3 sind das beispielhaft Zellen mit 70%, 80% und 90% der Nominalkapazität, die auch die restlichen Zellen 120 aufweisen. Da in der Reihenschaltung durch alle Zellen 110, 120 der gleiche Strom fließt, werden diese Zellen 110 mit geringerer Kapazität systematisch schneller entladen. Der gleiche Effekt tritt analog beim Laden der Zellen 110 auf.

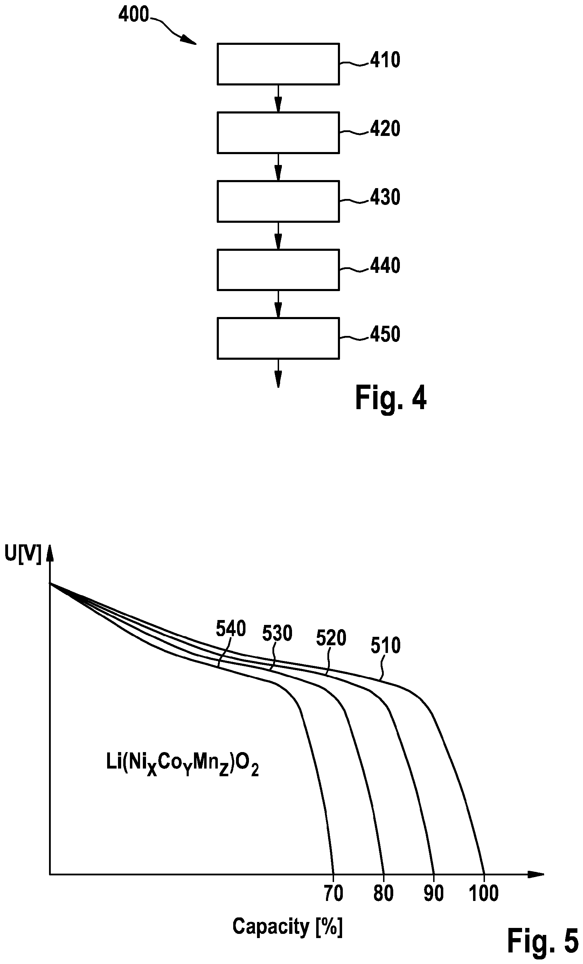

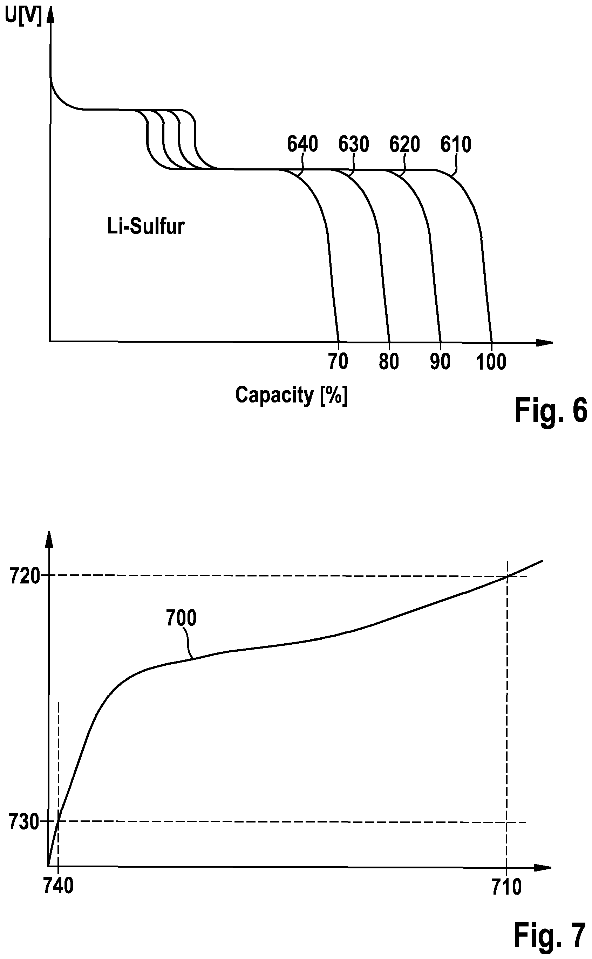

Bei der Entladung bewirkt diese Verschaltung, dass die erste Zelle 110a (70% der Nominalkapazität) bereits leer ist und folglich ein deutliches Absinken der Spannung zeigt, wenn die Kapazität der restlichen Zellen und damit auch der Gesamtbatterie noch bei 70% liegt. Gleiches passiert bei der zweiten und dritten Zelle in dieser Anordnung entsprechend bei 80% bzw. 90% (vgl. Fig. 5 für Li-NCM und Fig. 6 für Li-Schwefel-Systeme). Somit kann durch ein Abgreifen der Einzelspannungen dieser ersten Zellen 110 die Kapazität der Batterie 100 an den genannten diskreten Stellen sehr genau bestimmt werden. Dies ermöglicht dem Anwender eine sichere Abschätzung, wie viel Restkapazität zu diesen Zeitpunkten in der Batterie 100 noch enthalten ist.

Um die Zellen 110 mit geringerer Kapazität nicht tief zu entladen, was die Zellen 110 langfristig schädigen würde, können diese durch den in Fig. 1 bis Fig. 3 jeweils eingezeichneten schaltbaren Bypass an jeder dieser Zellen 110 überbrückt werden. Sie werden dann erst beim nächsten Laden der Batterie wieder geeignet in den Reihenstrang eingeschaltet.

Fig. 3 zeigt eine Verschaltung von Zellen unterschiedlicher Kapazität in Reihe von N Zellen 120, die alle die nominale Kapazität besitzen. Um die Zellen 110 mit kleinerer Kapazität zu überbrücken, wenn diese bereits leer (Ladezustand 0%) oder schon voll (Ladezustand 100%) sind, sind einzelne Schalter vor diesen Zellen angebracht, die dann einzeln und in der Regel über das Batteriemanagementsystem automatisiert, betätigt werden. Die Mess-Batteriezellen 110 sind als austauschbare Einheit konzipiert. Schalter 130 ermöglichen das Überbrücken einzelner Zellen 110, wenn deren Kapazität entladen ist.

Fig. 4 zeigt ein Ablaufdiagramm eines Ausführungsbeispiels der vorliegenden Erfindung als Verfahren 400. Das Verfahren 400 zum Verschalten von Batteriezellen in einer Batterie weist auf einen Schritt 410 des Anordnens von zumindest einer Standard-Batteriezelle in einer Reihenschaltung, einen Schritt 420 des Anordnens von zumindest einer Mess-Batteriezelle in der Reihenschaltung, einen Schritt 430 des Überwachens eines Ladezustands der zumindest einen Mess-Batteriezelle, einen Schritt 440 des Überbrückens der zumindest einen Mess-Batteriezelle unter Verwendung einer schaltbaren Überbrückung und einen Schritt 450 des Bestimmens des Ladezustand der Batterie unter Verwendung des Ladezustands der zumindest einen Mess-Batteriezelle und/oder einem im Schritt 440 des Überbrückens ausgegebenen Überbrückungssignal. Im Schritt 440 des Überbrückens wird die zumindest eine Mess-Batteriezelle überbrückt, wenn der Ladezustand der zumindest einen Mess-Batteriezelle eine vordefinierte Ladezustandsschwelle unterschreitet und/oder überschreitet. Die im Schritt 420 des Anordnens angeordnete Mess-Batteriezelle weist eine geringere Nominalkapazität auf als die im Schritt 410 des Anordnens angeordnete Standard-Batteriezelle.

In einem Ausführungsbeispiel der vorliegenden Erfindung wird im Schritt 410 des Anordnens eine Vielzahl von Standard-Batteriezellen in der Reihenschaltung angeordnet. Weiterhin werden im Schritt 420 des Anordnens eine Mehrzahl von Mess-Batteriezellen entsprechend ihrer jeweiligen Kapazität aufsteigend in der Reihenschaltung angeordnet. Dabei sind in einem Ausführungsbeispiel die im Schritt 420 des Anordnens angeordneten Mess-Batteriezellen als austauschbare Mess-Batteriezellen ausgebildet. In einem weiteren vorteilhaften Ausführungsbeispiel der vorliegenden Erfindung werden in den Schritten 410 und 420 des Anordnens eine Mehrzahl von Reihenschaltungen parallel angeordnet.

Das in Fig. 4 dargestellte Verfahren 400 zum Verschalten von Batteriezellen in einer Batterie kann durch den Schritt 450 des Bestimmens als Verfahren zur Bestimmung des Ladezustandes bei Batterien mit flacher Spannungskennlinie durch geeignete Verschaltung von Batteriezellen mit unterschiedlicher Kapazität verwendet werden.

Das geschilderte Verfahren lässt sich unter anderem beim Einsatz von Lithium-Ionen-Batterien in Elektrowerkzeugen, Gartengeräten, Computern, PDAs und Mobiltelefonen, in Hybrid- und Plug-in-Hybrid- sowie in Elektrofahrzeugen anwenden. Prinzipiell eignet sich hierfür jede Anwendung von Lithium-Ionen-Batterien, bei der eine genaue Bestimmung des Ladezustands erfolgen sollte, was nahezu jede Anwendung mit einschließt.

Fig. 5 zeigt einen Spannungsverlauf für Batteriezellen gleicher Zellchemie mit jeweils unterschiedlicher Nominalkapazität gemäß einem Ausführungsbeispiel der vorliegenden Erfindung. In einem kartesischen Koordinatensystem ist der Spannungsverlauf über die Kapazität aufgetragen für Batteriezellen vom Typ Li-NCM oder Li(NiₓCo_{y}MN_{z})O₂. Auf der Ordinate ist die Spannung in Volt angegeben, auf der Abszisse die Kapazität der Batteriezelle genormt in Prozent der Batteriezelle mit der größten Kapazität, welche mit 100 % Kapazität angegeben ist. Die Kurve 510 repräsentiert den Spannungsverlauf der Batteriezelle mit 100 % Kapazität, die Kurve 520 repräsentiert den Spannungsverlauf der Batteriezelle mit 90 % Kapazität, die Kurve 530 repräsentiert den Spannungsverlauf der Batteriezelle mit 80 % Kapazität und die Kurve 540 repräsentiert den Spannungsverlauf der Batteriezelle mit 70 % Kapazität. Allen Spannungsverläufen 510, 520, 530, 540 ist gemeinsam ein steter leicht fallender Spannungsverlauf bis ca. zur Hälfte der Nominalkapazität der Batteriezelle, gefolgt von einer Phase eines nur sehr geringen Spannungsabfalls bis kurz vor dem Entladen der Gesamtkapazität der Batteriezelle, wobei die Spannung zum Ende dieser zweiten Phase in etwa zwei Drittel der Spannung zu Beginn eines Entladevorgangs entspricht. Kurz vor Ende der vollständigen Entladung der Batteriezelle fällt der Spannungsverlauf fast senkrecht ab, sodass bei vollständiger Entladung der Batteriezelle keine Spannung mehr anliegt. Die vier dargestellten Spannungsverläufe 510, 520, 530, 540 starten alle bei der gleichen Spannung auf der Ordinate und enden entsprechend ihrer Nominalkapazität auf der Abszisse. Fig. 5 zeigt den Spannungsverlauf über der Kapazität aufgetragen, für Zellen mit jeweils unterschiedlicher Kapazität am Beispiel von Li-NCM. U Die Erfindung betrifft ein Verfahren zur Bestimmung des Ladezustands einer Batterie, bestehend aus mehreren Batteriezellen, deren Spannungskennlinien flach verlaufen, wodurch die übliche Bestimmung des Ladezustands durch Messen der Ruhespannung nicht sinnvoll möglich ist.

Fig. 6 zeigt einen Spannungsverlauf für Batteriezellen gleicher Zellchemie mit jeweils unterschiedlicher Nominalkapazität gemäß einem Ausführungsbeispiel der vorliegenden Erfindung. Der Spannungsverlauf der Li-Sulfur-Batteriezellen weist trotz unterschiedlicher Nominalkapazität einen vergleichbaren Spannungsverlauf während eines Entladevorgangs der Batteriezellen auf. In einem kartesischen Koordinatensystem ist auf der Ordinate die Spannung und auf der Abszisse die Kapazität der Batteriezellen dargestellt. Vier Spannungsverläufe 610, 620, 630, 640 zeigen die an der Batteriezelle anliegende Spannung über die noch vorhandene Kapazität in der Batteriezelle. Die Kurve 610 zeigt den Spannungsverlauf der als Referenz dienenden Batteriezelle mit 100 % Kapazität. Die Kurve 620 zeigt den Spannungsverlauf einer Batteriezelle, die im Vergleich zu der als Referenz dienenden Batteriezelle, welche in Kurve 610 dargestellt ist, eine Kapazität von 90 % aufweist. Die Kurve 630 zeigt den Spannungsverlauf einer Batteriezelle, die im Vergleich zu der als Referenz dienenden Batteriezelle, welche in Kurve 610 dargestellt ist, eine Kapazität von 80 % aufweist. Die Kurve 640 zeigt den Spannungsverlauf einer Batteriezelle, die im Vergleich zu der als Referenz dienenden Batteriezelle, welche in Kurve 610 dargestellt ist, eine Kapazität von 70 % aufweist. Die Abszisse zeigt die während eines Entladevorgangs einer Batteriezelle entnommene Kapazität. Der Spannungsverlauf der Kurve 610 endet bei 100 % Kapazität. Dementsprechend endet der Spannungsverlauf der Kurve 620 bei 90 %, der Kurve 630 bei 80 % und der Kurve 640 bei 70 %. Allen Spannungsverläufen gemein ist ein starker Abfall zu Beginn der Entladung ein in etwa ebenso großer Abfall des Spannungsverlaufs nach ungefähr einem Drittel der Entladung und ein in etwa doppelt so hoher Spannungsabfall bis auf null kurz vor Ende bzw. bis zum Ende der Entladung. Fig. 6 zeigt einen Spannungsverlauf über der Kapazität aufgetragen, für Zellen mit jeweils unterschiedlicher Kapazität, Bsp. Li-Schwefel.

Die in Fig. 5 und Fig. 6 gezeigten Spannungsverläufen zeigen deutlich, dass während des Entladevorgangs bis kurz vor der vollständigen Entladung keine zuverlässige Aussage über die in der Batteriezelle noch gespeicherte Restkapazität getroffen werden kann. Dies lässt sich durch eine erfindungsgemäße Fahrschaltung von Batteriezellen innerhalb einer Batterie kostengünstig und effizient verbessern.

In besonders hohem Maße sind die hier vorgestellten Ausführungsbeispiele der Erfindung für Plug-in-Hybrid- sowie Elektrofahrzeuge geeignet, da dort eine zuverlässige und belastbare Ermittlung des Batterieladezustands, insbesondere gegen Ende des Entladevorgangs möglich sein sollte.

Fig. 7 zeigt einen Spannungsverlauf einer Batteriezelle über den Ladezustand gemäß einem Ausführungsbeispiel der vorliegenden Erfindung. In einem kartesischen Koordinatensystem ist auf der Ordinate die Spannung aufgetragen und auf der Abszisse der Ladezustand in Prozent der Nominalladekapazität. Die Nominalkapazitätsschwelle 710 definiert die Nominalkapazität der Batteriezelle. Der in Fig. 7 gezeigte beispielhafte Spannungsverlauf zeigt den Ladezustand 700, welcher einem Spannungsverlauf während der Entladung einer Li-NCM Batteriezelle entspricht. Die Batteriezelle weist bei einem Ladezustand gleich der Nominalkapazitätsschwelle 710 eine Spannung 720 auf. Eine weitere hierzu geringere Spannung 730 charakterisiert eine vordefinierte Ladezustandsschwelle 740.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (400) zum Verschalten von Batteriezellen (110, 120) in einer Batterie (100), wobei die Batterie (100) eine Mehrzahl von Mess-Batteriezellen (110) und zumindest eine Standard-Batteriezelle (120) in einer Reihenschaltung aufweist, wobei die Mess-Batteriezellen (110) und die Standard-Batteriezelle (120) eine gleiche Zellchemie aufweisen, wobei eine Standard-Batteriezelle (120) mindestens eine Nominalkapazität aufweist, die größer als eine Nominalkapazitätsschwelle (710) ist, wobei die Mess-Batteriezellen (110) jeweils eine Nominalkapazität aufweisen, die kleiner als die Nominalkapazitätsschwelle (710) ist, wobei die Mess-Batteriezellen (110) jeweils eine schaltbare Überbrückung (130) aufweisen und wobei das Verfahren (400) die folgenden Schritte aufweist:
Überwachen (430) eines Ladezustands (700) der Mess-Batteriezellen (110);
Überbrücken (440) einer Mess-Batteriezelle (110) unter Verwendung der schaltbaren Überbrückung (130), wenn der Ladezustand (700) der Mess-Batteriezelle (110) eine vordefinierte Ladezustandsschwelle (740) unterschreitet;
Anordnen (410) der Mehrzahl von Mess-Batteriezellen (110), bei dem die Mess-Batteriezellen (110) entsprechend ihrer jeweiligen Kapazität in der Reihenschaltung aufsteigend angeordnet werden; und
Bestimmen (450) des Ladezustands der Batterie (100) unter Verwendung des Ladezustands (700) der Mess-Batteriezellen (110) und/oder eines im Schritt (440) des Überbrückens ausgegebenen Überbrückungssignals.

2. Verfahren (400) gemäß Anspruch 1, bei dem die Mess-Batteriezellen (110) als austauschbare Mess-Batteriezellen (110) in der Batterie (100) ausgebildet sind.

3. Verfahren (400) gemäß einem der vorangegangenen Ansprüche, mit einem Schritt (420) des Anordnens einer Vielzahl von Standard-Batteriezellen (120) in der Reihenschaltung.

4. Verfahren (400) gemäß einem der Ansprüche 1 bis 3, bei dem im Schritt (410) des Anordnens eine weitere Mehrzahl von Mess-Batteriezellen (110) und im Schritt (420) des Anordnens eine weitere Mehrzahl von Standard-Batteriezellen (120) in einer weiteren Reihenschaltung innerhalb einer Batterie (100) angeordnet werden.

5. Verfahren (400) gemäß einem der vorangegangenen Ansprüche, bei dem im Schritt (440) des Überbrückens die zumindest eine Mess-Batteriezelle (110) überbrückt wird, wenn der Ladezustand (700) der zumindest einen Mess-Batteriezelle (110) eine weitere vordefinierte Ladezustandsschwelle überschreitet, wobei die weitere vordefinierte Ladezustandsschwelle der Nominalkapazität der Mess-Batteriezelle (110) entspricht.

6. Überwachungseinrichtung, die Einrichtungen aufweist, die ausgebildet sind, um die Schritte eines Verfahrens (400) gemäß einem der Ansprüche 1 bis 5 durchzuführen.

7. Batterie (100), die eine Mehrzahl von Batteriezellen (110, 120) gleicher Zellchemie in einer Reihenschaltung aufweist, wobei die Batterie (100) die folgenden Merkmale aufweist:
zumindest eine Standard-Batteriezelle (120), die mindestens eine Nominalkapazität aufweist, die größer als eine Nominalkapazitätsschwelle (710) ist;
eine Mehrzahl von Mess-Batteriezellen (110), die jeweils eine Nominalkapazität aufweisen, die kleiner als die Nominalkapazitätsschwelle (710) ist, wobei die Mess-Batteriezellen (110) jeweils eine schaltbare Überbrückung (130) aufweisen und entsprechend ihrer jeweiligen Kapazität in der Reihenschaltung aufsteigend angeordnet sind; und
eine Überwachungseinrichtung gemäß Anspruch 6.

8. Computer-Programmprodukt mit Programmcode zur Durchführung des Verfahrens (400) nach einem der Ansprüche 1 bis 5, wobei das Computer-Programmprodukt auf einer Überwachungseinrichtung ausgeführt wird.

## Claims

1. Method (400) for connecting battery cells (110, 120) in a battery (100), wherein the battery (100) has a plurality of measuring battery cells (110) and at least one standard battery cell (120) in a series circuit, wherein the measuring battery cells (110) and the standard battery cell (120) have the same cell chemistry, wherein a standard battery cell (120) has at least a nominal capacity which is greater than a nominal capacity threshold (710),wherein the measuring battery cells (110) each have a nominal capacity which is lower than the nominal capacity threshold (710), wherein the measuring battery cells (110) each have a switchable bridge (130), and wherein the method (400) comprises the following steps:
monitoring (430) a state of charge (700) of the measuring battery cells (110);
bridging (440) a measuring battery cell (110) using the switchable bridge (130) when the state of charge (700) of the measuring battery cell (110) falls below a predefined state of charge threshold (740);
arranging (410) the plurality of measuring battery cells (110), during which the measuring battery cells (110) are arranged in ascending order in accordance with their respective capacity in the series circuit; and determining (450) the state of charge of the battery (100) using the state of charge (700) of the measuring battery cells (110) and/or a bridge signal which is output in the bridging step (440).

2. Method (400) according to Claim 1, in which the measuring battery cells (110) are in the form of replaceable measuring battery cells (110) in the battery (100) .

3. Method (400) according to either of the preceding claims, comprising a step (420) of arranging a large number of standard battery cells (120) in the series circuit.

4. Method (400) according to one of Claims 1 to 3, in which, in the arrangement step (410), a further plurality of measuring battery cells (110) and, in the arrangement step (420), a further plurality of standard battery cells (120) are arranged in a further series circuit within a battery (100).

5. Method (400) according to one of the preceding claims, in which, in the bridging step (440), the at least one measuring battery cell (110) is bridged when the state of charge (700) of the at least one measuring battery cell (110) exceeds a further predefined state of charge threshold, wherein the further predefined state of charge threshold corresponds to the nominal capacity of the measuring battery cell (110).

6. Monitoring device which has devices which are designed in order to carry out the steps of a method (400) according to one of Claims 1 to 5.

7. Battery (100) which has a plurality of battery cells (110, 120) of the same cell chemistry in a series circuit, wherein the battery (100) has the following features:
at least one standard battery cell (120) which has at least a nominal capacity which is greater than a nominal capacity threshold (710);
a plurality of measuring battery cells (110) which each have a nominal capacity which is lower than the nominal capacity threshold (710), wherein the measuring battery cells (110) each have a switchable bridge (130) and are arranged in ascending order in accordance with their respective capacity in the series circuit; and
a monitoring device according to Claim 6.

8. Computer program product having program code for carrying out the method (400) according to one of Claims 1 to 5, wherein the computer program product is executed on a monitoring device.

## Revendications

1. Procédé (400) d'interconnexion de cellules de batterie (110, 120) dans une batterie (100), la batterie (100) possédant une pluralité de cellules de batterie de mesure (110) et au moins une cellule de batterie standard (120) dans un circuit série, les cellules de batterie de mesure (110) et la cellule de batterie standard (120) possédant une chimie de cellule identique, une cellule de batterie standard (120) possédant au moins une capacité nominale qui est supérieure à un seuil de capacité nominale (710), les cellules de batterie de mesure (110) possédant respectivement une capacité nominale qui est inférieure au seuil de capacité nominale (710), les cellules de batterie de mesure (110) possédant respectivement un pontage commutable (130) et le procédé (400) comprenant les étapes suivantes :
surveillance (430) d'un état de charge (700) des cellules de batterie de mesure (110) ;
pontage (440) d'une cellule de batterie de mesure (110) en utilisant le pontage commutable (130) lorsque l'état de charge (700) de la cellule de batterie de mesure (110) devient inférieur à un seuil d'état de charge (740) prédéfini ;
arrangement (410) de la pluralité de cellules de batterie de mesure (110), selon lequel les cellules de batterie de mesure (110) sont arrangées dans le circuit série conformément à l'ordre croissant de leur capacité respective ; et
détermination (450) de l'état de charge de la batterie (100) en utilisant l'état de charge (700) des cellules de batterie de mesure (110) et/ou un signal de pontage délivré à l'étape (440) de pontage.

2. Procédé (400) selon la revendication 1, selon lequel les cellules de batterie de mesure (110) sont réalisées sous la forme de cellules de batterie de mesure (110) remplaçables dans la batterie (100).

3. Procédé (400) selon l'une des revendications précédentes, comprenant une étape (420) d'arrangement d'une pluralité de cellules de batterie standard (120) dans le circuit série.

4. Procédé (400) selon l'une des revendications 1 à 3, selon lequel, dans l'étape (410) d'arrangement, une pluralité supplémentaire de cellules de batterie de mesure (110), et dans l'étape (420) d'arrangement une pluralité supplémentaire de cellules de batterie standard (120), sont arrangées dans un circuit série supplémentaire à l'intérieur d'une batterie (100).

5. Procédé (400) selon l'une des revendications précédentes, selon lequel, à l'étape (440) de pontage, l'au moins une cellule de batterie de mesure (110) est pontée lorsque l'état de charge (700) de l'au moins une cellule de batterie de mesure (110) devient supérieur à un seuil d'état de charge prédéfini supplémentaire, le seuil d'état de charge prédéfini supplémentaire correspondant à la capacité nominale de la cellule de batterie de mesure (110).

6. Dispositif de surveillance, lequel possède des dispositifs qui sont configurés pour mettre en oeuvre les étapes d'un procédé (400) selon l'une des revendications 1 à 5.

7. Batterie (100), laquelle possède une pluralité de cellules de batterie (110, 120) ayant une chimie de cellule identique dans un circuit série, la batterie (100) possédant les caractéristiques suivantes :
au moins une cellule de batterie standard (120), laquelle possède au moins une capacité nominale qui est supérieure à un seuil de capacité nominale (710) ;
une pluralité de cellules de batterie de mesure (110), lesquelles possèdent respectivement une capacité nominale qui est inférieure au seuil de capacité nominale (710), les cellules de batterie de mesure (110) possédant respectivement un pontage commutable (130) et étant arrangées dans le circuit série conformément à l'ordre croissant de leur capacité respective ; et
un dispositif de surveillance selon la revendication 6.

8. Produit de programme informatique comprenant un code de programme destiné à mettre en oeuvre le procédé (400) selon l'une des revendications 1 à 5, le produit de programme informatique étant exécuté sur un dispositif de surveillance.
